# EUROPÄISCHE PATENTSCHRIFT

(11) **EP 2 591 318 B1**
(45) Veröffentlichungstag und Bekanntmachung des Hinweises auf die Patenterteilung: **25.10.2017**
(21) Anmeldenummer: 11741530.7
(22) Anmeldetag: 20.06.2011
(51) Int. Cl.: G01F 1/684, G01F 1/692, G01K 1/08, G01K 7/16, G01K 13/02, H01L 29/40

(54) **MESSAUFNEHMER EINES THERMISCHEN DURCHFLUSSMESSGERÄTS ZUR ERMITTLUNG DES DURCHFLUSSES EINES MEDIUMS DURCH EIN MESSROHR UND VERFAHREN ZU DESSEN HERSTELLUNG**
PROBE OF A THERMAL FLOW METER, FOR MEASURING THE FLOW THROUGH A MEASURING PIPE AND METHOD FOR IT'S FABRICATION
CAPTEUR DE MESURE DE DÉBITMÈTRE THERMIQUE POUR DÉTERMINER LE DÉBIT D'UN MILIEU DANS UN TUBE DE MESURE ET PROCÉDÉ DE PRODUCTION DUDIT CAPTEUR DE MESURE

(30) Priorität: 08.07.2010 DE 102010031127
(43) Veröffentlichungstag der Anmeldung: 15.05.2013
(73) Patentinhaber: Endress+Hauser Flowtec AG, 4153 Reinach (CH)
(72) Erfinder: BAUR, Tobias, 4145 Reinach (CH); CHRISTODOULOU, Fanos, 2322 Lakatameia (CY); PFAU, Axel, 4147 Aesch (CH); BARTH, Martin, 4057 Basel (CH); LANG, Arno, 79379 Müllheim (DE)
(74) Vertreter: Andres, Angelika Maria
(86) Internationale Anmeldenummer: PCT/EP2011/060205
(87) Internationale Veröffentlichungsnummer: WO 2012/004117

(56) Entgegenhaltungen:
- EP-A2- 0 580 323
- EP-A2- 2 093 548
- WO-A1-2009/146447
- WO-A2-2009/115452
- DE-U1- 9 408 085

## Beschreibung

Die vorliegende Erfindung betrifft einen Messaufnehmer eines thermischen Durchflussmessgeräts zum Ermitteln des Durchflusses eines durch ein Messrohr strömendes Medium und ein Verfahren zu dessen Herstellung, wobei der Messaufnehmer zumindest ein Dünnfilm-Widerstandsthermometer aufweist, welches in einer Hülse angeordnet ist, wobei die Hülse ein erstes Ende aufweist, aus welchem zumindest ein Kabel zur elektrischen Kontaktierung des Dünnfilm-Widerstandsthermometers aus der Hülse herausgeführt ist, wobei das Kabel in der Hülse zumindest abschnittsweise in ein erstes Füllmaterial eingebettet ist.

Herkömmliche thermische Durchflussmessgeräte verwenden üblicherweise zwei möglichst gleichartig ausgestaltete Temperatursensoren, die in, meist stiftförmigen, Metallhülsen, so genannten Stingers oder Prongs, angeordnet sind und die in thermischem Kontakt mit dem durch ein Messrohr oder durch die Rohrleitung strömenden Medium sind, meist sind sie in das Medium eingetaucht. Für die industrielle Anwendung sind beide Temperatursensoren üblicherweise in ein Messrohr eingebaut; die Temperatursensoren können aber auch direkt in der Rohrleitung montiert sein. Einer der beiden Temperatursensoren ist ein sog. aktiver Temperatursensor, der mittels einer Heizeinheit beheizt wird. Als Heizeinheit ist entweder eine zusätzliche Widerstandsheizung vorgesehen, oder bei dem Temperatursensor selbst handelt es sich um ein Widerstandselement, z.B. um einen RTD-(Resistance Temperature Device) Sensor, der durch Umsetzung einer elektrischen Leistung, z.B. durch eine entsprechende Variation des Messstroms erwärmt wird. Bei dem zweiten Temperatursensor handelt es sich um einen sog. passiven Temperatursensor: Er misst die Temperatur des Mediums.

Üblicherweise wird in einem thermischen Durchflussmessgerät der beheizbare Temperatursensor so beheizt, dass sich eine feste Temperaturdifferenz zwischen den beiden Temperatursensoren einstellt. Alternativ ist es auch bekannt geworden, über eine Regel-/Steuereinheit eine konstante Heizleistung einzuspeisen.

Tritt in dem Messrohr kein Durchfluss auf, so wird eine zeitlich konstante Wärmemenge zur Aufrechterhaltung der vorgegebenen Temperaturdifferenz benötigt. Ist hingegen das zu messende Medium in Bewegung, ist die Abkühlung des beheizten Temperatursensors wesentlich von dem Massedurchfluss des vorbeiströmenden Mediums abhängig. Da das Medium kälter ist als der beheizte Temperatursensor, wird durch das vorbeiströmende Medium Wärme von dem beheizten Temperatursensor abtransportiert. Um also bei einem strömenden Medium die feste Temperaturdifferenz zwischen den beiden Temperatursensoren aufrecht zu erhalten, ist eine erhöhte Heizleistung für den beheizten Temperatursensor erforderlich. Die erhöhte Heizleistung ist ein Maß für den Massedurchfluss bzw. den Massestrom des Mediums durch die Rohrleitung.

Wird hingegen eine konstante Heizleistung eingespeist, so verringert sich infolge des Durchflusses des Mediums die Temperaturdifferenz zwischen den beiden Temperatursensoren. Die jeweilige Temperaturdifferenz ist dann ein Maß für den Massedurchfluss des Mediums durch die Rohrleitung bzw. durch das Messrohr.

Es besteht somit ein funktionaler Zusammenhang zwischen der zum Beheizen des Temperatursensors notwendigen Heizenergie und dem Massedurchfluss durch eine Rohrleitung bzw. durch ein Messrohr. Die Abhängigkeit des sog. Wärmeübertragungskoeffizienten von dem Massedurchfluss des Mediums durch das Messrohr bzw. durch die Rohrleitung wird in thermischen Durchflussmessgeräten zur Bestimmung des Massedurchflusses genutzt. Geräte, die auf diesem Prinzip beruhen, werden von der Anmelderin unter der Bezeichnung ,t-switch', ,t-trend' oder 't-mass' angeboten und vertrieben.

Bisher wurden hauptsächlich RTD-Elemente mit wendelförmig gewickelten Platindrähten in thermischen Durchflussmessgeräten eingesetzt. Bei Dünnfilm-Widerstandsthermometern (TFRTDs) wird herkömmlicherweise eine mäanderförmige Platinschicht auf ein Substrat aufgedampft. Darüber wird eine weitere Glasschicht zum Schutz der Platinschicht aufgebracht. Der Querschnitt der Dünnfilm-Widerstandsthermometern ist im Unterschied zu den, einen runden Querschnitt aufweisenden RTD-Elementen, rechteckig. Die Wärmeübertragung in das Widerstandselement und/oder aus dem Widerstandselement erfolgt demnach über zwei gegenüberliegende Oberflächen, welche zusammen einen Großteil der Gesamtoberfläche eines Dünnfilm-Widerstandsthermometers ausmachen.

Der Einbau eines quaderförmigen Dünnfilm-Widerstandsthermometers in eine runde Stifthülse wird in der US-PS 6,971,274 und der US-PS 7,197,953 folgendermaßen gelöst. In eine Distanzbuchse aus Metall mit einer rechteckigen Vertiefung wird das Dünnfilm-Widerstandsthermometer so eingesetzt, dass zumindest die zwei gegenüberliegenden großen Oberflächen des Dünnfilm-Widerstandsthermometers quasi spaltfreien Kontakt zu den ihnen gegenüberliegenden Oberflächen der Distanzbuchse haben. Die Distanzbuchse weist dazu eine rechteckige Vertiefung auf, welche entsprechend der Außenmaße des Dünnfilm-Widerstandsthermometers gefertigt ist. Die Distanzbuchse soll den Dünnfilm-Widerstandsthermometer eng halten. Dazu bilden Distanzbuchse und Dünnfilm-Widerstandsthermometer quasi eine Presspassung. Die Distanzbuchse selbst und die Stifthülse bilden ebenfalls eine Presspassung. Dadurch wird der Einsatz einer Vergussmasse oder eines anders gearteten Füllmaterials überflüssig. Der Vorteil dieses Aufbaus besteht in einer allseitigen guten Wärmekopplung zwischen Dünnfilm-Widerstandsthermometer und Messmedium durch die Distanzbuchse. Allerdings entstehen durch den festen Sitz des Dünnfilm-Widerstandsthermometers und/oder durch unterschiedliche Wärmeausdehnungskoeffizienten der beteiligten Materialen mechanische Spannungen im Dünnfilm-Widerstandsthermometer.

Ein solcher Messaufnehmer ist durch die WO 2009/115452 A2 gezeigt. Die zum Zeitpunkt dieser Patentanmeldung nicht offen gelegte deutsche Patentanmeldung mit dem Aktenzeichen 102009028850.3 zeigt ein dazu verfeinertes Verfahren zur Herstellung eines Temperatursensors, insbesondere für ein thermisches Durchflussmessgerät, mit mindestens einer rohrförmigen Stifthülse mit einem ersten offenen Ende und einem zweiten offenen Ende, welches erste offene Ende der Stifthülse in einem Sensorhalter gehaltert wird, mit weiterhin mindestens einem Widerstandsthermometer mit einer ersten Oberfläche und mindestens einer der ersten Oberfläche gegenüberliegenden zweiten Oberfläche, wobei durch das zweite offene Ende der Stifthülse ein Distanzstück mit einem, auf seiner ersten Oberfläche befestigten, Widerstandsthermometer in die Stifthülse eingesetzt wird und das zweite offene Ende der Stifthülse anschließend mit einem Stopfen verschlossen wird.

Die Offenlegungsschrift WO 2009/146447 A1 offenbart einen Temperatursensor in einer Hülse, eingebettet in einem ersten Füllmaterial, und mit Kabeln versehen, welche in einem zweiten Füllmaterial eingebettet sind.

Die Patentschrift DE 10 2007 023 824 B4 offenbart einen thermischen Massendurchflussmesser mit mindestens einem Heizelement, welches auf einem Halter montiert ist, welcher Halter in das Medium eingetaucht ist. Der Halter weist dabei zwei Zonen differierender Wärmeleitfähigkeiten auf. In einer kurzen Zone geringer Wärmeleitfähigkeit ist das Heizelement angeordnet. In einer langen Zone hoher Wärmeleitfähigkeit sind die Anschlussdrähte des Heizelements elektrisch isoliert angeordnet. Die Zone geringer Wärmeleitfähigkeit ist beispielsweise mit Luft gefüllt. Die lange Zone hoher Wärmeleitfähigkeit ist in bevorzugter Ausgestaltung durch gepresstes Metalloxid gebildet. Das Problem von mechanischen Spannungen, insbesondere bei Temperaturschwankungen, am Dünnfilm-Widerstandssensor und an den Kabeln wird nicht näher beleuchtet.

Auch die DE 40 03 638 C2 zeigt einen ähnlichen Aufbau, das Heizelement ist von Luft umgeben, jedoch ist der verbleibende Raum in der Hülse mit Gießharz ausgefüllt.

Die Patentschrift DE 10 2006 034 246 B3 offenbart nun einen Temperaturfühler für ein Widerstandsthermometer. Ein Messwiderstand ist von Füllstoff auf der Grundlage eines keramischen oder mineralischen Materials bedeckt. Wenigstens ein Anschlussdraht ist jedoch nicht von Füllstoff bedeckt. Zum Ausgleich temperaturbedingten mechanischen Spannungen in den Drähten, ist eine Dehnungsausgleichseinrichtung vorgesehen - die Drähte weisen eine Biegung auf. Die temperaturbedingten mechanischen Spannungen entstehen durch unterschiedliche Wärmeausdehnungskoeffizienten der verwendeten Materialen und durch Einsatz des Sensors in einem Abgasstrang von Verbrennungsmotoren, in welchem bis zu 1000°C vorherrschen können.

Gleiches gilt für den Gegenstand der in der Druckschrift EP 2 093 548 A2 beschrieben wird. Hier wird als Füllmaterial ein Hochtemperaturzement genutzt.

Die Druckschrift EP 0 580 323 A2 offenbart in zwei Ausführungsvarianten jeweils einen Thermistor und einer weichen Füllmasse, welche um den Thermistor herum angeordnet ist.

Die Druckschrift DE 0 94 08 085 offenbart einen Meßfühler zur Durchflussüberwachung mit einem Meßsystem. Dieses ist mit einem gutwärmeleitenden Füllstoff unbekannter Härte umgeben. Die vom Meßsystem abgehenden Kabel sind mit einem Keramikblock eingefasst.

Die Aufgabe der Erfindung besteht darin, ein Messaufnehmer für ein thermisches Durchflussmessgerät vorzuschlagen, welcher robust gegenüber Temperaturschwankungen ist.

Die Aufgabe wird gelöst durch den Gegenstand des unabhängigen Anspruchs 1 und durch den Gegenstand des unabhängigen Anspruchs 7. Weiterbildungen und Ausgestaltungen der Erfindung finden sich in den Merkmalen der jeweils abhängigen Ansprüche wider.

Ein erfindungsgemäßer Messaufnehmer eines thermischen Durchflussmessgeräts, insbesondere der industriellen Prozesstechnik, zum Ermitteln des Durchflusses eines durch ein Messrohr strömendes Medium, weist zumindest ein, insbesondere genau ein, beheizbares oder unbeheiztes Dünnfilm-Widerstandsthermometer auf. Dieses ist in einer einseitig verschlossenen Hülse angeordnet ist, wobei die Hülse ein erstes offenes Ende aufweist, aus welchem zumindest ein Kabel zur elektrischen Kontaktierung des Widerstandsthermometers aus der Hülse herausgeführt ist. Dieses erste offene Ende wird beispielsweise in einem Sensorhalter des thermischen Durchflussmessgeräts befestigt. Üblicherweise sind zwei oder mehr Kabel zur Kontaktierung des Dünnfilm-Widerstandsthermometers vorgesehen. Die Kabel in der Hülse sind zumindest abschnittsweise in ein erstes Füllmaterial eingebettet.

Das Dünnfilm-Widerstandsthermometer ist in der Hülse von einem zweiten Füllmaterial zumindest teilweise bedeckt. Das zweite Füllmaterial ist dabei ein Gas oder ein Gasgemisch, beispielsweise Luft, oder es ist eine Flüssigkeit, auch eine hochviskose und damit zähflüssige Flüssigkeit oder ein Gel, oder das zweite Füllmaterial besteht aus einem losen Pulver oder es ist bei 1013mbar und 20°C fest, beispielsweise auch ein gepresstes Pulver, welches zweite Füllmaterial dann eine Härte von höchstens Shore A 90, insbesondere höchstens Shore A 70 aufweist. Auch das erste Füllmaterial ist entweder zähflüssig oder fest und weist dann eine Härte von höchstens Shore D 98, insbesondere höchstens Shore D 70 auf. Weitere Füllmaterialen werden durch übliche Vergussmassen oder Epoxidharze gebildet. Diese sind bei der Herstellung zähflüssig und härten zu einem Feststoff aus. Gemäß einer ersten Weiterbildung der Erfindung sind das erste und das zweite Füllmaterial nicht identisch. Insbesondere ist das zweite Füllmaterial weicher als das erste Füllmaterial.

Ein erfindungsgemäßes thermisches Durchflussmessgerät weist zumindest einen erfindungsgemäßen Messaufnehmer auf. Verwendung finden erfindungsgemäße thermische Durchflussmessgeräte vor allem in der Prozessindustrie. Es handelt sich dann um ein Gerät der industriellen Prozessmesstechnik. Die Betriebsbedingungen solcher Geräte richten sich nach den Prozessbedingungen. Übliche Temperaturbereiche der Prozesse der industriellen Prozesstechnik liegen zwischen - 50°C und +350°C, bei Drücken bis zu 200bar.

Gemäß einem Ausführungsbeispiel ist sowohl das erste Füllmaterial, als auch das zweite Füllmaterial bei 20°C und bei 1013mbar fest und zwischen dem ersten Füllmaterial und dem zweiten Füllmaterial ist ein drittes Füllmaterial, insbesondere ein Gas oder ein Gasgemisch, wie beispielsweise Luft, in der Hülse eingeschlossen. Als drittes Füllmaterial sind aber darüber hinaus auch wiederum flüssige und zähflüssige oder feste Materialen denkbar. Ein Beispiel für ein zähflüssiges Füllmaterial ist Sielgel. Einen festen Aggregatszustand weisen beispielsweise auch gepresste Pulver, wie z.B. gepresste Metalloxide auf, selbst wenn diese eine gewisse Porosität aufweisen.

Ist als drittes Füllmaterial ein Gas oder ein Gasgemisch zwischen dem ersten Füllmaterial und dem zweiten Füllmaterial in der Hülse eingeschlossen, ist impliziert, dass die Hülse an einem ersten Ende durch das erste Füllmaterial, insbesondere gasdicht, verschlossen ist.

Als Alternativen zu Luft als zweitem Füllmaterial sind beispielsweise um Epoxy-Gießharze, wie z.B. die von Cotronics vertriebenen Epoxidharze Durapont 868, zu nennen. Beim ersten Füllmaterial handelt es sich beispielsweise um Epoxy-Gießharze mit den Handelnamen Durapot 861 oder Stycast 2850.

In einer Ausführungsform weist das erste Füllmaterial einen Wärmeausdehnungskoeffizienten von höchstens 10*10⁻⁵ 1/K (linear), insbesondere höchstens 3,8*10⁻⁵ 1/K (linear) auf. Das zweite Füllmaterial ist dann entweder gasförmig, flüssig oder zähflüssig, oder es weist einen Wärmeausdehnungskoeffizienten von ebenfalls höchstens 10*10⁻⁵ 1/K (linear), insbesondere 3,8*10⁻⁵ 1/K (linear) auf. Eine übliche Silikonfüllung weist z.B. eine Wärmeleitfähigkeit von ca. 0,2 W/(mK) auf. Ist ein drittes Füllmaterial zwischen dem ersten und dem zweiten Füllmaterial vorgesehen, so beträgt dessen Wärmeausdehnungskoeffizient höchstens 30*10⁻⁵ 1/K (linear). Die Hülse besteht herkömmlicherweise aus einem Edelstahl, z.B. einer Nickelbasislegierung. So liegt die Wärmeleitfähigkeit von X2CrNiMo 17-12-3 oder auch 1.4404 bei 15W/(mK), bei einem Wärmeausdehnungskoeffizienten α von ca. 13-18*10⁻⁶K⁻¹. Zum Vergleich liegt die Wärmeleitfähigkeit von reinem Kupfer bei ca. 400W/(mK), welches beispielsweise für ein Distanzstück zwischen Hülse und Dünnfilm-Widerstandsthermometer verwendet wird.

Die Kabel zur Kontaktierung des Dünnfilm-Widerstandsthermometers sind an zumindest einem Punkt mit dem Dünnfilm-Widerstandsthermometer verbunden z.B. durch Bonden. Die Länge jedes einzelnen Kabels zwischen dem Punkt der Verbindung des Kabels mit dem Dünnfilm-Widerstandsthermometer und dem ersten Ende der Hülse ist dabei wesentlich größer als die Länge des Abstands zwischen dem Punkt der Verbindung des Kabel mit dem Dünnfilm-Widerstandsthermometer und dem ersten Ende der Hülse. Sie beträgt insbesondere mindestens 105 %, insbesondere mindestens 107% oder gar mindestens 110% des Abstands zwischen dem Punkt der Verbindung des Kabels mit dem Dünnfilm-Widerstandsthermometer und dem ersten Ende der Hülse. Das Kabel ist beispielsweise in einem vorgegebenen Abschnitt gebogen oder gewickelt. Dadurch wird ein Dehnungsausgleichsmechanismus gebildet. Eine Zugkraft angelegt an ein Kabel im Bereich des ersten Endes der Hülse oder außerhalb der Hülse wird nicht direkt auf das Dünnfilm-Widerstandsthermometer übertragen, da die Biegung oder die Wicklung, allgemein der Dehnungsausgleichsmechanismus, elastisch ist, sich sehr einfach verformen lässt und dadurch nicht die gesamte Zugkraft übertragen wird.

Dazu ist dieser Abschnitt beispielsweise in ein gasförmiges, flüssiges oder zähflüssiges Füllmaterial eingebettet. Entweder direkt in das zweite Füllmaterial oder, falls das zweite Füllmaterial dafür nicht geeignet scheint, z.B. fest ist, in das dritte Füllmaterial, zwischen dem ersten und zweiten Füllmaterial.

Der Abstand zwischen dem zweitem Füllmaterial und dem erstem Füllmaterial, also die Ausdehnung des dritten Füllmaterials längs der Längsachse der Hülse, ist dann mindestens so groß, um den Dehnungsausgleichsmechanismus vollständig einzubetten, z.B. mindestens das 5-fache des Innendurchmessers der Hülse. Die Kabeldicke beträgt in diesem Beispiel dann höchstens 1/10 des Innendurchmessers der Hülse.

In einem Ausgestaltungsbeispiel ist das Dünnfilm-Widerstandsthermometer auf einem Distanzstück angebracht, welches Distanzstück zwischen Dünnfilm-Widerstandsthermometer und Hülse angeordnet ist. Das Distanzstück wird bei der Montage des Messaufnehmers mitsamt dem darauf angebrachten Dünnfilm-Widerstandsthermometer in die Hülse eingeführt, insbesondere durch ein zweites offenes Ende der Hülse. Die Hülse weist dabei zwei offene Enden auf, ein erstes und ein zweites. Das Dünnfilm-Widerstandsthermometer wird durch das zweite offene Ende in die Hülse eingeführt, wobei die mit dem Dünnfilm-Widerstandsthermometer verbundenen Kabel aus der Hülse durch das erste offene Ende herausgeführt werden. Nach dem Einführen des Dünnfilm-Widerstandsthermometers in die Hülse wird das zweite offene Ende beispielsweise mit einem Stopfen verschlossen. Ein Stopfen ragt naturgemäß zumindest Abschnittsweise in die zweite Hülse hinein. Alternativ ist die Hülse mit einer Kappe zu verschließen. Der Stopfen wird beispielsweise mittels eines Laserschweißverfahrens mit der Hülse verschweißt und verschließt diese dicht. Zum Erleichtern des Einschiebens des Stopfens kann dieser an einem ersten Ende eine Fase aufweisen.

Bei dem Distanzstück handelt es sich beispielsweise um ein zylindrisch geformten Körper mit einer Nut. Zur guten Wärmeleitung besteht es z.B. aus Kupfer und geht eine Presspassung mit der Hülse ein. Das Dünnfilm-Widerstandsthermometer ist beispielsweise auf das Distanzstück gelötet, insbesondere in dessen Nut.

Die Erfindung lässt zahlreiche Ausführungsformen zu. Einige davon sollen hier kurz anhand der nachfolgenden Figuren näher erläutert werden. Gleiche Elemente sind in den Figuren mit gleichen Bezugszeichen versehen.
- Fig. 1: zeigt einen nicht erfindungsgemäßen, hier ebenfalls beschriebenen Messaufnehmer in einer ersten Ausgestaltung im Längsschnitt,
- Fig. 2: zeigt einen erfindungsgemäßen Messaufnehmer in einer zweiten Ausgestaltung im Längsschnitt,
- Fig. 3: zeigt einen nicht erfindungsgemäßen, hier ebenfalls beschriebenen Messaufnehmer in einer dritten Ausgestaltung im Längsschnitt,
- Fig. 4: zeigt perspektivisch einen erfindungsgemäßen Messaufnehmer ohne Füllmaterial,
- Fig. 5: zeigt eine weitere Ausgestaltung einer Dehnungsausgleichseinrichtung,
- Fig. 6: zeigt eine weitere Ausgestaltung einer Dehnungsausgleichseinrichtung,
- Fig. 7: zeigt eine weitere Ausgestaltung einer Dehnungsausgleichseinrichtung.

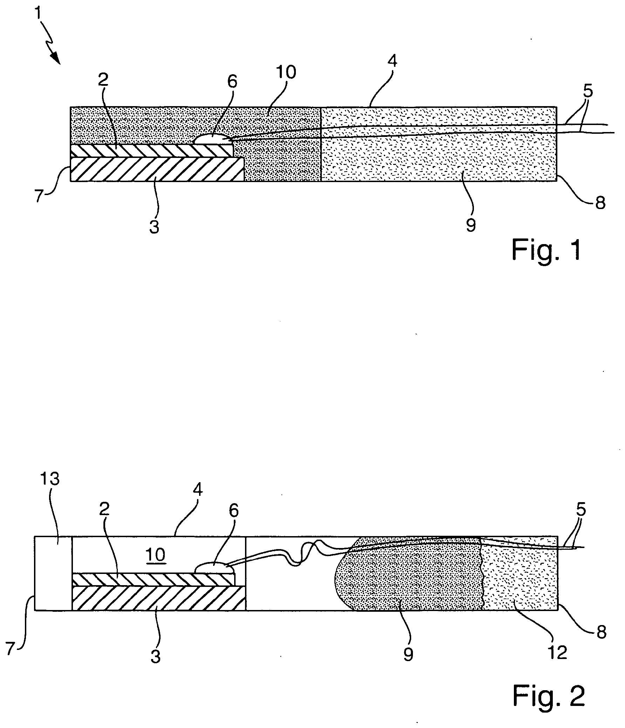

In Fig. 1 ist ein nicht erfindungsgemäßer, hier ebenfalls beschriebener Messaufnehmer 1 im Längsschnitt dargestellt. Der Messaufnehmer 1 ist zur Verwendung in einem thermischen Durchflussmessgerät, zum Ermitteln des Durchflusses eines durch ein Messrohr strömendes Medium, ausgestaltet. Ein Dünnfilm-Widerstandsthermometer (TFRTD) 2 ist auf einem Distanzstück 3 in einer Hülse 4 angeordnet. Das Distanzstück 3 befindet sind zwischen der Hülse 4 und dem Dünnfilm-Widerstandsthermometer 2. Es besteht bevorzug aus einem gut Wärme leitenden Material, wie z.B. Kupfer. Das Dünnfilm-Widerstandsthermometer 2 ist in diesem Beispiel auf das Distanzstück 3 angelötet. Auf der dem Distanzstück 3 abgewandten Seite des Dünnfilm-Widerstandsthermometers 2 sind Kabel 5 zur elektrischen Kontaktierung des Dünnfilm-Widerstandsthermometers 2 an einem Punkt 6 mit dem Dünnfilm-Widerstandsthermometer 2 verbunden. Die Verbindung der Kabel 5 mit dem Dünnfilm-Widerstandsthermometer 2 wird beispielsweise durch Schweißen hergestellt. Die Verbindung der Kabel 5 mit dem Dünnfilm-Widerstandsthermometer 2 ist hier durch einen Tropfen Abdeckpaste 6 dargestellt. Die Verbindung der Kabel 5 mit dem Dünnfilm-Widerstandsthermometer 2 wird auch als Bonding bezeichnet. Die Seite des Dünnfilm-Widerstandsthermometers 2 mit dem Tropfen Abdeckpaste 6 ist von einem zweiten Füllmaterial 10 bedeckt, hier eine Vergussmasse, wie beispielsweise ein Epoxidharz, wie Durapont 868, mit einer Härte von Shore A 85. Die Hülse 4 weist ein erstes, hier offenes Ende 8 auf, aus welchem die Kabel 5 aus der Hülse 4 herausgeführt sind und ein zweites, hier geschlossenes Ende 7 auf. Beispielsweise weist die Hülse die Form einer Eprouvette auf. Das zweite Füllmaterial 10 füllt die Hülse im Bereich seines zweiten Endes 7 vollständig aus. Jedoch ist nicht die gesamte Hülse 4 mit dem zweiten Füllmaterial 10 ausgefüllt. Im Bereich des ersten Endes 8 der Hülse 4 ist die Hülse 4 mit einem ersten Füllmaterial 9 ausgefüllt. In dieses erste Füllmaterial 9 sind die Kabel 5 eingebettet. Hier besteht das erste Füllmaterial beispielsweise aus Durapot 861 mit einer Härte von Shore D80.

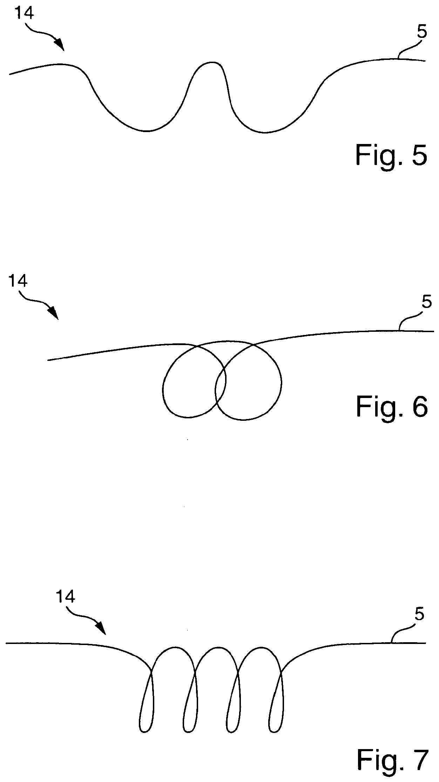

Fig. 2 zeigt einen erfindungsgemäßen Messaufnehmer 1 im Längsschnitt, mit einem in einer Hülse 4 angeordneten Dünnfilm-Widerstandsthermometer 2. Auch hier weist die Hülse 4 ein erstes, offenes Ende 8 auf, aus welchem Kabel 5 zur elektrischen Kontaktierung des Dünnfilm-Widerstandsthermometers 2 aus der Hülse 4 herausgeführt sind und ein zweites Ende 7 auf. Das zweite Ende 7 der Hülse 4 ist durch einen Stopfen 13 geschlossen. Die Hülse 4 weist also zwei offene Enden 7 und 8 auf, wobei das zweite, zunächst offene Ende 7 durch einen Stopfen 13 verschlossen wird, insbesondere nachdem das Dünnfilm-Widerstandsthermometer 2 durch das zunächst offene zweite Ende 7 der Hülse 4 in die Hülse 4 eingeführt wurde. Zunächst werden Kabel 5 in einem vorgegebenen Bereich bzw. Abschnitt der Kabel 5 nach vorgegebener Art und Weise gebogen, gewickelt oder spiralisiert, so dass eine Dehnungsausgleichseinrichtung entsteht und die Kabel einer Kraft elastisch nachgeben können. Die Kabel 5 werden anschließend am Dünnfilm-Widerstandsthermometer 2 befestigt, beispielsweise werden sie daran angeschweißt oder angelötet. Die Lötstelle ist sehr klein und wird hier der Einfachheit halber als Lötpunkt bezeichnet und dargestellt mit der Abdeckpaste 6. Das Dünnfilm-Widerstandsthermometer 2 wird anschließend auf ein Distanzstück 3 gelötet und mit diesem in die Hülse 4 durch ihr zweites offenes Ende 7 eingeführt oder es wird direkt in die Hülse 4 durch ihr zweites offenes Ende 7 eingeführt, wobei die Kabel 5 durch das erste offene Ende 8 der Hülse aus der Hülse 4 herausgeführt werden. Anschließend kann das zweite offene Ende 7 der Hülse 4 mit einem Stopfen 13 verschlossen werden und erstes Füllmaterial 9 durch das erste offene Ende 8 der Hülse 4 in die Hülse 4 eingefüllt werden, so dass das Dünnfilm-Widerstandsthermometer 2 von zweitem Füllmaterial 10, hier erfindungsgemäß Luft, bedeckt ist und die Kabel 5 großteils in erstem Füllmaterial 9 eingebettet sind, wobei die Kabel 5 im Bereich der Dehnungsausgleichseinrichtung, also in diesem Ausführungsbeispiel im gebogenen Abschnitt, nicht vom ersten Füllmaterial 9 eingebettet sind. Diese sind in diesem Beispiel vom zweiten Füllmaterial 10 umgeben. Weitere Ausgestaltungsbeispiele für Dehnungsausgleichseinrichtungen sind in den Figuren 5-7 dargestellt.

Alternativ wird, je nach Ausgestaltung des Distanzstücks 3, das Dünnfilm-Widerstandsthermometer 2 vor dem Einführen des Distanzstücks 3 in die Hülse mit Vergussmasse vergossen. Das Distanzstück 3 ist hier als Distanzstück mit Nut ausgestaltet, wie es aus dem Stand der Technik gemäß der WO 2009/115452 A2 bereits bekannt ist. Es geht eine Presspassung mit der Hülse 4 ein. Der Stopfen 13 ragt in die Hülse 4 hinein. Mit dem Einschieben des Stopfens 13 kann auch das Distanzstück 3 in die Hülse 4 eingeschoben werden. In dieser Ausgestaltung ist ein weiteres Befestigen des Dünnfilm-Widerstandsthermometers 2 in der Hülse 4 nicht notwendig. Wird das Dünnfilm-Widerstandsthermometer 2 in der Hülse 4 ohne Distanzstück 3 eingebracht, kann dieser ohne zusätzlichen Befestigungsschritt mit dem Einbringen des zweiten Füllmaterials 10, beispielsweise einem Verguss, in der Hülse 4 befestigt werden. Besteht das zweite Füllmaterial 10 aus einem Gas oder ist es gel- oder honigartig, kann das Dünnfilm-Widerstandsthermometer 2 vor dem Einbringen des zweiten Füllmaterials 10 an der Hülse befestigt werden, indem es z.B. angeklebt oder angelötet wird.

Wie bereits beschrieben, wird die Menge des ersten Füllmaterials 9 so bemessen, dass das Dünnfilm-Widerstandsthermometer 2 und der gebogene Abschnitt 14 oder der spulenförmig gewickelte Abschnitt oder der helixförmig gewickelte Abschnitt des Kabels 5 nicht von erstem Füllmaterial 9 bedeckt oder eingebettet sind. In diesem Ausführungsbeispiel weist der Messaufnehmer 1 in der Hülse 4 ein weiteres, viertes Füllmaterial 12 auf, welches nach dem Einfüllen des ersten Füllmaterials 9 durch das offene erste Ende 8 der Hülse 4 eingefüllt wird.

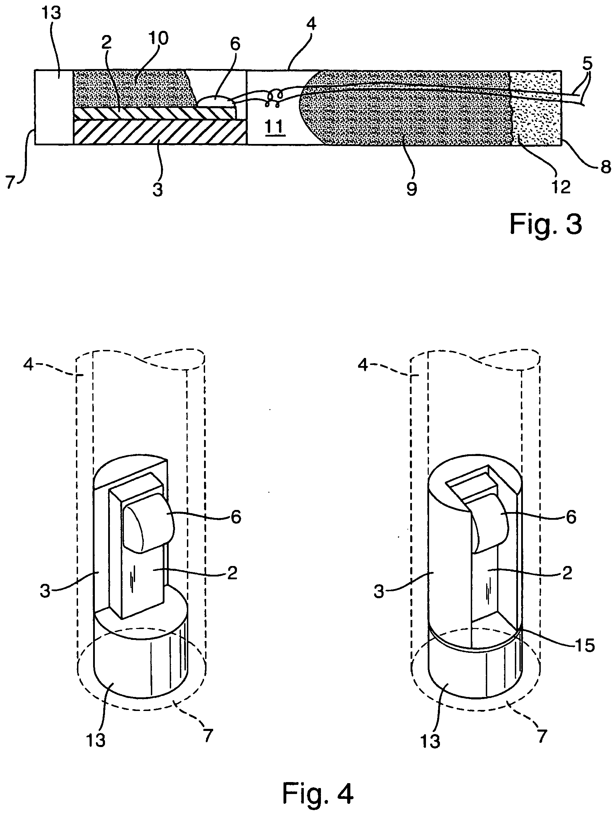

In Fig. 3 ist ein weiterer nicht erfindungsgemäßer, hier ebenfalls beschriebener Messaufnehmer 1 veranschaulicht. In die Hülse 4 ist ein Dünnfilm-Widerstandsthermometer 2 eingebracht, welcher von einem zweiten Füllmaterial 10 bedeckt ist. Dieses weist eine Härte geringer Shore A 90 auf. Vom zweiten Ende 7 der Hülse 4 ausgehend zum ersten Ende 8 der Hülse 4 weiter betrachtet, folgt ein drittes Füllmaterial 11 in welchem die Dehnungsausgleichseinrichtung 14 der Kabel 5 eingebettet sind. Das dritte Füllmaterial 11 besteht erfindungsgemäß aus einem Gas oder Gasgemisch, ist flüssig oder hochviskos. Hier ist ein Sielgel verwendet. Das dritte Füllmaterial 11 wird von der Hülse 4 und dem ersten Füllmaterial 9 und zweiten Füllmaterial 10 umschlossen. Nach dem ersten Füllmaterial 9, in welches die Kabel größtenteils eingebettet sind, folgt noch ein viertes Füllmaterial 12, welches das erste offene Ende 8 der Hülse verschließt.

Hergesellt wird ein solcher Messaufnehmer 1 beispielsweise folgendermaßen. Das Dünnfilm-Widerstandsthermometer 2 wird auf dem Distanzstück 3 angelötet und anschließend mit einem zweiten Füllmaterial 10 vergossen. Nach dem Einsetzen des Distanzstücks 3 in die Hülse 4 und gleichzeitigem Herausführen der Kabel 5 aus der Hülse 4 aus deren offenem Ende 8, wird das dritte Füllmaterial 11 in die Hülse eingefüllt, danach das erste Füllmaterial 9 und abschließend das vierte Füllmaterial 12.

Alternativ wird das Distanzstück 3 mit aufgelötetem Dünnfilm-Widerstandsthermometer 2 in die Hülse durch deren offenes zweites Ende 7 eingeführt und danach mit zweitem Füllmaterial 10 bedeckt. Ob dies durch das zweite offene Ende 7 oder das erste offene Ende 8 der Hülse 4, dann mit geschlossenem oder offenen zweiten Ende 7 der Hülse 4, hängt von den jeweiligen Füllmaterialen ab. Bevorzugt wird die Reihenfolge zunächst das Dünnfilm-Widerstandsthermometer 2 auf das Distanzstück 3 zu löten, die Dehnungsausgleichseinrichtung 14 der Kabel 5 herzustellen, das Distanzstück 3 mitsamt dem Widerstandsthermometer 2 und den Kabeln 5 in die Hülse 4 einzubringen und das zweite offene Ende 7 der Hülse 4 mit einem Stopfen zu verschließen. Anschließend wird das erste, zweite, dritte und gegebenenfalls vierte Füllmaterial durch das erste offene Ende 8 der Hülse 4 eingebracht.

Dies erfolgt beispielsweise mittels einer Dosiernadel, welche in die Hülse 4 eingeführt wird und durch welche das jeweilige Füllmaterial eingebracht wird. Die Nadel wird entsprechend dem Füllmaterial in der Hülse positioniert und während des Befüllvorgangs in Richtung erstes offenes Ende der Hülse aus der Hülse herausgeführt, mit einer Geschwindigkeit, welche der Füllgeschwindigkeit der Hülse entspricht. Die Viskosität des entsprechenden Füllmaterials, beeinflusst durch Kohäsionskräft, bestimmt das Fließverhalten eines Gießharzes, wie z.B. des Durapont 861, welches bei Raumtemperatur aushärtet, maßgeblich. Durch Auswahl der Bedingungen beim Befüllen der Hülse, wie z.B. Temperatur des Füllmaterials, Temperatur der Hülse oder Umgebungsdruck und Befüllwinkel der Hülse, kann das Füllmaterial an einer vorgegebenen Stelle positioniert werden.

Die Mengen der Füllmaterialen, insbesondere des ersten Füllmaterials 9 und/oder des zweiten Füllmaterials 10 sind bei vorliegenden Produktionsbedingungen so bemessen, dass das Dünnfilm-Widerstandsthermometer 2 von dem zweiten Füllmaterial 10 zumindest teilweise bedeckt ist und gegebenenfalls, dass die Ausdehnung des dritten Füllmaterials 11 längs der Längsachse der Hülse 4 mindestens das 5-fache des Innendurchmessers der Hülse 4 beträgt, wobei der Abschnitt des Kabels 5 mit dem gebogenen, gewickelten oder spiralisierten Kabel 5 im dritten Füllmaterial 11 eingebettet ist.

Weitere Zwischenschritte zur Befestigung des Dünnfilm-Widerstandsthermometers 2 auf dem Distanzstück 3, zur Herstellung des Distanzstücks 3 oder des Stopfens 13 oder zum Verschluss des zweiten offenen Endes 7 der Hülse 4 sind durch die DE 10 2009 028 850.3 dem Fachmann bekannt.

Der erfindungsgemäße Messaufnehmer in Fig. 4 weist ein Distanzstück zwischen Hülse 4 und Dünnfilm-Widerstandsthermometer 2 auf. In dieser Ansicht sind keine Füllmaterialen dargestellt. Der Stopfen 13 weist eine Fase 15 auf, um ihn spanfrei in die Hülse 4 einzuschieben. Die Kabel 5 sind über einen Löt- oder Schweißpunkt an den Dünnfilm- Widerstandsthermometer 2 gebondet, welcher mit Abdeckpaste 6 abgedeckt ist.

In den Fig. 5 bis Fig. 7 sind weitere mögliche Dehnungsausgleichseinrichtungen 14 skizziert. Die Kabel 5 sind in einem Abschnitt im Bereich des dritten Füllmaterials 11, in welches sie ebenfalls eingebettet sind, gebogen, gewickelt, gefaltet, gewunden, verdrillt oder spiralisiert. In Fig. 5 sind sie zu einem ω doppelt gebogen, in Fig. 6 zu 2 Schlaufen gewickelt und in Fig. 7 zu einer Helix mit 4 Wicklungen spiralisiert.

### Bezugszeichenliste

- 1: Messaufnehmer
- 2: Dünnfilm-Widerstandsthermometer
- 3: Distanzstück
- 4: Hülse
- 5: Kabel
- 6: Abdeckpaste (Bonding)
- 7: Zweites Ende der Hülse
- 8: Erstes Ende der Hülse
- 9: Erstes Füllmaterial
- 10: Zweites Füllmaterial
- 11: Drittes Füllmaterial
- 12: Viertes Füllmaterial
- 13: Stopfen
- 14: Dehnungsausgleichseinrichtung des Kabels
- 15: Fase

## Patentansprüche

1. Messaufnehmer eines thermischen Durchfilussmessgeräts zum Ermitteln des Durchflusses eines durch ein Messrohr strömendes Medium, welcher Messaufnehmer zumindest ein Dünnfilm-Widerstandsthermometer aufweist, welches in einer Hülse angeordnet ist, wobei die Hülse ein erstes Ende aufweist, aus welchem zumindest ein Kabel zur elektrischen Kontaktierung des Dünnfilm-Widerstandsthermometers aus der Hülse herausgeführt ist, wobei das Kabel in der Hülse zumindest abschnittsweise in ein erstes Füllmaterial eingebettet ist,
**dadurch gekennzeichnet,**
**dass** das Dünnfilm-Widerstandsthermometer von einem zweiten Füllmaterial zumindest teilweise bedeckt ist,
und wobei das zweite Füllmaterial Luft ist,
und wobei die Hülse aus einem Edelstahl besteht,
und wobei das erste Füllmaterial ein Gießharz ist.

2. Messaufnehmer nach Anspruch 1,
**dadurch gekennzeichnet, dass** das erste Füllmaterial ein Epoxidharz ist.

3. Messaufnehmer nach einem der Ansprüche 1 bis 2,
**dadurch gekennzeichnet,**
**dass** das Kabel an zumindest einem Punkt mit dem Dünnfilm-Widerstandsthermometer verbunden ist, und dass das Kabel zwischen dem Punkt der Verbindung des Kabels mit dem Dünnfilm-Widerstandsthermometer und dem ersten Ende der Hülse eine Länge aufweist, die um mindestens 7% größer ist, als der Abstand zwischen dem Punkt der Verbindung des Kabel mit dem Dünnfilm-Widerstandsthermometer und dem ersten Ende der Hülse.

4. Messaufnehmer nach einem der Ansprüche 1 bis 5,
**dadurch gekennzeichnet,**
**dass** das Dünnfilm-Widerstandsthermometer auf einem Distanzstück angebracht ist, welches Distanzstück zwischen Dünnfilm-Widerstandsthermometer und Hülse angeordnet ist.

5. Messaufnehmer nach einem der Ansprüche 1 bis 4,
**dadurch gekennzeichnet,**
**dass** ein zweites Ende der Hülse mittels eines Stopfens verschlossen ist.

6. Messaufnehmer nach einem der Ansprüche 1 bis 5,
**dadurch gekennzeichnet,**
**dass** zwischen dem ersten Füllmaterial und dem ersten Ende der Stifthülse ein viertes Füllmaterial die Hülse ausfüllt.

7. Verfahren zur Herstellung eines Messaufnehmers gemäß einem der Ansprüche 1 bis 6, wobei das zweite Ende der Hülse offen ist,
**gekennzeichnet durch folgende Verfahrensschritte:**
Biegen, Wickeln oder Spiralisieren des Kabels in einem vorgegebenen Abschnitt des Kabels,
Befestigen des Kabels zur elektrischen Kontaktierung des Dünnfilm-Widerstandsthermometers am Dünnfilm-Widerstandsthermometer,
Einführen des Dünnfilm-Widerstandsthermometer in die Hülse durch das zweite offene Ende der Hülse, wobei die Kabel durch das erste offene Ende der Hülse aus der Hülse herausgeführt werden,
Einbringen des ersten Füllmaterials durch das erste offene Ende der Hülse.

8. Verfahren zur Herstellung eines Messaufnehmers nach Anspruch 7,
**dadurch gekennzeichnet,**
**dass** vor dem Einführen des Dünnfilm-Widerstandsthermometers in die Hülse, das Dünnfilm-Widerstandsthermometer auf dem Distanzstück angebracht wird, und das Distanzstück mit dem Dünnfilm-Widerstandsthermometer in die Hülse eingeführt wird, und dass nach dem Einführen des Dünnfilm-Widerstandsthermometers in die Hülse das zweite offene Ende mit einem Stopfen verschlossen wird.

9. Verfahren zur Herstellung eines Messaufnehmers nach Anspruch 8,
**dadurch gekennzeichnet,**
**dass** das Distanzstück im Wesentlichen eine zylindrische Form und eine Nut parallel zu einer Längsachse des Distanzstücks aufweist, in welcher Nut das Dünnfilm-Widerstandsthermometers angebracht wird, wobei nach dem Anbringen des Dünnfilm-Widerstandsthermometers auf dem Distanzstück und vordem Einführen des Dünnfilm-Widerstandsthermometers in die Hülse, die Nut des Distanzstücks mit zweiten Füllmaterial so ausgefüllt wird, dass das Dünnfilm-Widerstandsthermometer vom zweiten Füllmaterial zumindest teilweise bedeckt ist.

10. Verfahren zur Herstellung eines Messaufnehmers nach Anspruch 7,
**dadurch gekennzeichnet,**
**dass** nach dem Einführen des Dünnfilm-Widerstandsthermometers in die Hülse das zweite Füllmaterial durch das zweite offene Ende der Hülse eingebracht wird.

## Claims

1. Sensor of a thermal flowmeter designed to determine the flow of a medium flowing through a measuring tube said sensor having at least one thin-film resistance thermometer, which is arranged in a sleeve, wherein the sleeve has a first end from which at least one cable leads out of the sleeve for the electrical connection of the thin-film resistance thermometer, wherein the cable in the sleeve is at least partially embedded in a first filling material,
**characterized in that**
the thin-film resistance thermometer is at least partially covered by a second filling material,
and wherein the second filling material is air,
and wherein the sleeve is made from stainless steel,
and wherein the first filling material is a cast resin.

2. Sensor as claimed in Claim 1,
**characterized in that**
the first filling material is epoxy resin.

3. Sensor as claimed in one of the Claims 1 to 2,
**characterized in that**
the cable is connected to the thin-film resistance thermometer at at least one point, and **in that** the cable between the point of connection of the cable with the thin-film resistance thermometer and the first end of the sleeve has a length that is at least 7% greater than the distance between the point of the connection of the cable with the thin-film resistance thermometer and the first end of the sleeve.

4. Sensor as claimed in one of the Claims 1 to 5,
**characterized in that**
the thin-film resistance thermometer is arranged on a spacer which itself is arranged between the thin-film resistance thermometer and the sleeve.

5. Sensor as claimed in one of the Claims 1 to 4,
**characterized in that**
a second end of the sleeve is sealed by a stopper.

6. Sensor as claimed in one of the Claims 1 to 5,
**characterized in that**
between the first filling material and the first end of the sleeve, a fourth filling material fills the sleeve.

7. Procedure for producing a sensor as claimed in one of the Claims 1 to 6, wherein the second end of the sleeve is open,
**characterized by the following process steps:**
Bending, coiling or spiraling of the cable in a predefined section of the cable,
Securing of the cable for the electrical connection of the thin-film resistance thermometer on the thin-film resistance thermometer,
Introduction of the thin-film resistance thermometer into the sleeve through the second open end of the sleeve, wherein the cables lead out of the sleeve through the first open end of the sleeve,
Introduction of the first filling material through the first open end of the sleeve.

8. Procedure for producing a sensor as claimed in Claim 7,
**characterized in that**
before the thin-film resistance thermometer is introduced into the sleeve, the thin-film resistance thermometer is fitted on the spacer and the spacer is introduced into the sleeve along with the thin-film resistance thermometer, and **in that** once the thin-film resistance thermometer is introduced into the sleeve the second open end is sealed with a stopper.

9. Procedure for producing a sensor as claimed in Claim 8,
**characterized in that**
the spacer is essentially cylindrical in shape and has a groove parallel to a longitudinal axis of the spacer, in said groove the thin-film resistance thermometer is arranged, wherein - after the thin-film resistance thermometer has been fitted on the spacer and before the thin-film resistance thermometer is inserted into the sleeve - the groove of the spacer is filled with the second filling material in such a way that the thin-film resistance thermometer is at least partially covered by the second filling material.

10. Procedure for producing a sensor as claimed in Claim 7,
**characterized in that**
once the thin-film resistance thermometer has been introduced into the sleeve, the second filling material is introduced through the second open end of the sleeve.

## Revendications

1. Capteur d'un débitmètre thermique destiné à la détermination du débit d'un produit s'écoulant à travers un tube de mesure, lequel capteur comporte au minimum un thermomètre à résistance à couche mince, lequel est installé dans une douille, la douille présentant une première extrémité, à partir de laquelle est sorti de la douille au moins un câble pour l'établissement d'un contact électrique du thermomètre à résistance à couche mince, le câble étant noyé dans la douille au moins par parties dans un premier matériau de remplissage,
**caractérisé**
**en ce que** le thermomètre à résistance à couche mince est recouvert au moins partiellement par un deuxième matériau de remplissage,
le deuxième matériau de remplissage étant de l'air,
la douille étant en acier inoxydable
et le premier matériau de remplissage étant une résine de coulée.

2. Capteur selon la revendication 1,
**caractérisé**
**en ce que** le premier matériau de remplissage est une résine époxy.

3. Capteur selon l'une des revendications 1 à 2,
**caractérisé**
**en ce que** le câble est relié au minimum en un point avec le thermomètre à résistance à couche mince, et **en ce que** le câble présente, entre le point de liaison du câble avec le thermomètre à résistance à couche mince et la première extrémité de la douille, une longueur qui est supérieure d'au moins 7 % à la distance entre le point de liaison du câble avec le thermomètre à résistance à couche mince et la première extrémité de la douille.

4. Capteur selon l'une des revendications 1 à 5,
**caractérisé**
**en ce que** le thermomètre à résistance à couche mince est installé sur une pièce d'écartement, laquelle pièce d'écartement est disposée entre le thermomètre à résistance à couche mince et la douille.

5. Capteur selon l'une des revendications 1 à 4,
**caractérisé**
**en ce qu'**une deuxième extrémité de la douille est obturée au moyen d'un bouchon.

6. Capteur selon l'une des revendications 1 à 5,
**caractérisé**
**en ce que**, entre le premier matériau de remplissage et la première extrémité de la douille à pointe, un quatrième matériau de remplissage remplit la douille.

7. Procédé destiné à la fabrication d'un capteur selon l'une des revendications 1 à 6, pour lequel la deuxième extrémité de la douille est ouverte,
**caractérisé par les étapes de procédé suivantes :**
Cintrage, enroulement ou spiralisation du câble dans une section prédéfinie du câble,
Fixation du câble pour l'établissement d'un contact électrique du thermomètre à résistance à couche mince sur le thermomètre à résistance à couche mince,
Introduction du thermomètre à résistance à couche mince dans la douille à travers la deuxième extrémité ouverte de la douille, le câble étant sorti de la douille à travers la première extrémité ouverte de la douille,
Remplissage du premier matériau de remplissage à travers la première extrémité ouverte de la douille.

8. Procédé destiné à la fabrication d'un capteur selon la revendication 7,
**caractérisé**
**en ce qu'**avant l'introduction du thermomètre à résistance à couche mince dans la douille, le thermomètre à résistance à couche mince est installé sur la pièce d'écartement, et **en ce que** la pièce d'écartement est introduite avec le thermomètre à résistance à couche mince dans la douille, et **en ce qu'**après l'introduction du thermomètre à résistance à couche mince dans la douille, la deuxième extrémité ouverte est obturée au moyen d'un bouchon.

9. Procédé destiné à la fabrication d'un capteur selon la revendication 8,
**caractérisé**
**en ce que** la pièce d'écartement est pour l'essentiel de forme cylindrique et comporte une rainure parallèle à un axe longitudinal de la pièce d'écartement, rainure dans laquelle le thermomètre à résistance à couche mince est installé, la rainure de la pièce d'écartement étant remplie, après l'installation du thermomètre à résistance à couche mince sur la pièce d'écartement et avant l'introduction du thermomètre à résistance à couche mince dans la douille, avec un deuxième matériau de remplissage de telle sorte que le thermomètre à résistance à couche mince soit recouvert au moins partiellement par le deuxième matériau de remplissage.

10. Procédé destiné à la fabrication d'un capteur selon la revendication 7,
**caractérisé**
**en ce qu'**après l'introduction du thermomètre à résistance à couche mince dans la douille, le deuxième matériau de remplissage est introduit à travers la deuxième extrémité ouverte de la douille.
